# EUROPEAN PATENT SPECIFICATION

(11) **EP 3 618 598 B1**
(45) Date of publication and mention of the grant of the patent: **15.11.2023**
(21) Application number: 19192690.6
(22) Date of filing: 20.08.2019
(51) Int. Cl.: H05K 7/20

(54) **HOT/COLD AISLE SYSTEM**
HEISS/KALT-REGAL-SYSTEM
SYSTÈME D'ALLÉE CHAUDE/FROIDE

(30) Priority: 20.08.2018 EP 18189823; 21.12.2018 IE S20180574
(43) Date of publication of application: 04.03.2020
(73) Proprietor: Breffni Air Ireland Limited, Co. Cavan Co. Cavan (IE)
(72) Inventor: SHEANON, Patrick, County Monaghan (IE); FITZSIMONS, Hugo, County Meath (IE); SMITH, Kieran, County Cavan A82 R2X4 (IE)
(74) Representative: Schütte, Gearoid

(56) References cited:
- EP-A1- 3 163 992
- WO-A1-2017/129448
- US-A1- 2012 181 906
- US-A1- 2014 254 089
- US-A1- 2015 342 094
- US-A1- 2018 132 385

## Description

### Introduction

This invention relates to a hot/cold aisle system for a data centre.

In a data centre it is known to provide a hot or cold aisle associated with rows of server switch cabinets to deliver cooling air to the server switch cabinets and remove hot air from the server switch cabinets. Essentially, an aisle is formed between two adjacent parallel rows of server switch cabinets. A data centre may have many rows of server switch cabinets housed in a building. Usually the aisles are built in-situ. Commonly a frame is constructed extending upwardly from the server cabinets and cladded with panels to form a sealed enclosure to direct cooling air to or hot air away from the server switch cabinets. As such frames are constructed from a number of frame elements which have to be bolted together to construct the frame, and given the large number of aisles that typically need to be provided in a data centre, this is a time-consuming and tedious task. It also may delay, or be delayed by, the installation of other services at the data centre. Typically, workers carrying out different tasks on the same site at the same time will cause delays for each other. Further, there is a safety concern, not alone with respect to the workers constructing the aisles on site, but also with regard to other workers on the site at the same time.

The present invention is directed towards overcoming these problems.

US 2018/132385 A1, EP 3163992 A1, WO 2017/129448 A1 and US 2014/254089 A1 disclose various known aisle containment systems for data centres.

### Summary of the Invention

According to the invention, there is provided a hot/cold aisle system for a data centre, including:
a prefabricated self-supporting rigid frame having a top and downwardly depending sides defining an aisle,
a plurality of side panels mounted along each side to close the sides of the frame, and means for mounting the frame on a support,
characterised in that a roof is mounted at the top of the frame to close the top of the frame, and an L-shaped receiver strip is mounted on an inner face of each of the bottom rail and the top rail for reception of a window panel therebetween, and lower and upper retaining plates are provided at the bottom rail and at the top rail respectively to secure the window panels between the bottom rail and the top rail, the lower retaining plate having a downwardly extending flap for sealing engagement with a server cabinet in the data centre in use.

In one embodiment of the invention, the side panels are mounted edge to edge along each side between a bottom rail and a top rail of the frame.

In another embodiment, the frame sides include a pair of spaced-apart upright side walls interconnected at their upper ends by a plurality of spaced-apart cross beams forming the top of the frame, said cross beams being perpendicular to the side walls, each side wall comprising a bottom rail and a top rail which are mutually parallel and interconnected by a plurality of spaced-apart uprights with diagonal bracing elements mounted between each adjacent pair of uprights.

In another embodiment, each rail comprises an outwardly facing channel.

In another embodiment, at least one side panel comprises a window panel having a translucent window pane mounted on a support frame.

In another embodiment, all the side panels are window panels.

In another embodiment, each window panel comprises a rectangular outer window frame defining a stepped opening for reception of the window pane, retaining strips engagable within the stepped opening with an inner face of associated sides of the outer window frame to retain the window pane within the stepped opening, each retaining strip having a window pane retaining flange at an inner end for cooperation with an inwardly extending window pane mounting flange on the outer window frame at a periphery of the stepped opening to clamp the window pane therebetween, and cooperating tapered mating faces at an outer end of each retaining strip and on the inner face of the window frame sides for moving the pane retaining flange and pane mounting flange together and apart, and fasteners engagable between each retaining strip and the outer frame to secure the retaining strip on the outer frame.

In another embodiment, the outer window frame comprises a P-section frame member having an outer wall and an inner wall which are parallel and spaced-apart by an outer end wall extending therebetween and perpendicular to the outer wall and the inner wall, the outer wall extending inwardly from the outer end wall further than the inner wall to form the window pane mounting flange, an inner end wall projecting inwardly from the inner wall towards the outer wall and being cranked intermediate its ends to form the tapered mating face.

In another embodiment, each retaining strip is of Z-section having a central web parallel to the outer end wall, with the window pane retaining flange at an inner end of the central web, perpendicular thereto and parallel to the window pane mounting flange of the outer window frame, a sliding flange at an outer end of the central web folded inwardly over an outer face of the central web at an acute angle to form the tapered mating face.

In another embodiment, a U-shaped insert is mounted within each P-section frame member, having parallel sides interconnected by a cross-member, the sides abutting the outer end wall and the inner end wall, a fastener comprising a locking bolt engagable through associated openings in the central web and the inner end wall with a locknut on an innermost side of the insert for securing the retaining strip on the outer window frame.

In another embodiment, the means for mounting the frame on a support comprises a plurality of spaced-apart hangers at the top of the frame for suspending the frame from an overhead support.

In another embodiment, the means for mounting the frame on a support comprises a plurality of spaced-apart feet extending downwardly from a bottom of the frame to support the frame at a desired height above a floor on which the aisle system stands in use.

In another embodiment, a number of the side wall uprights extend downwardly of the bottom rail to form the feet.

In another embodiment, a door assembly is mounted at each end of the rigid frame.

In another embodiment, the door assembly comprises an upper panel extending between the sides of the rigid frame and between a top and a bottom of the rigid frame, and a door frame mounted below the upper panel and extending downwardly therefrom for engagement with the ground below the aisle system in use, with a door mounted on the door frame.

In another embodiment, the door comprises a rectangular outer frame within which a window pane is mounted.

In another aspect, the invention provides a method for assembling a hot/cold aisle system including the steps of pre-fabricating the hot/cold aisle system in a factory, transporting the hot/cold aisle system to the data centre and installing the hot/cold aisle system at the data centre.

### Brief Description of the Drawings

The invention will be more clearly understood by the following description of some embodiments thereof, given by way of example only, with reference to the accompanying drawings, in which:

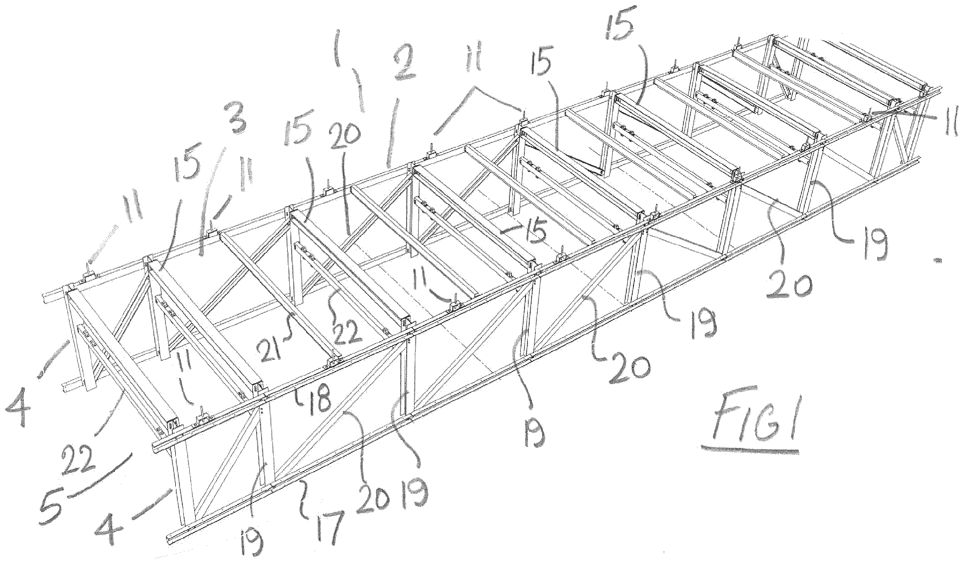

Fig. 1 is a perspective view of a frame of a hot/cold aisle system according to the invention;

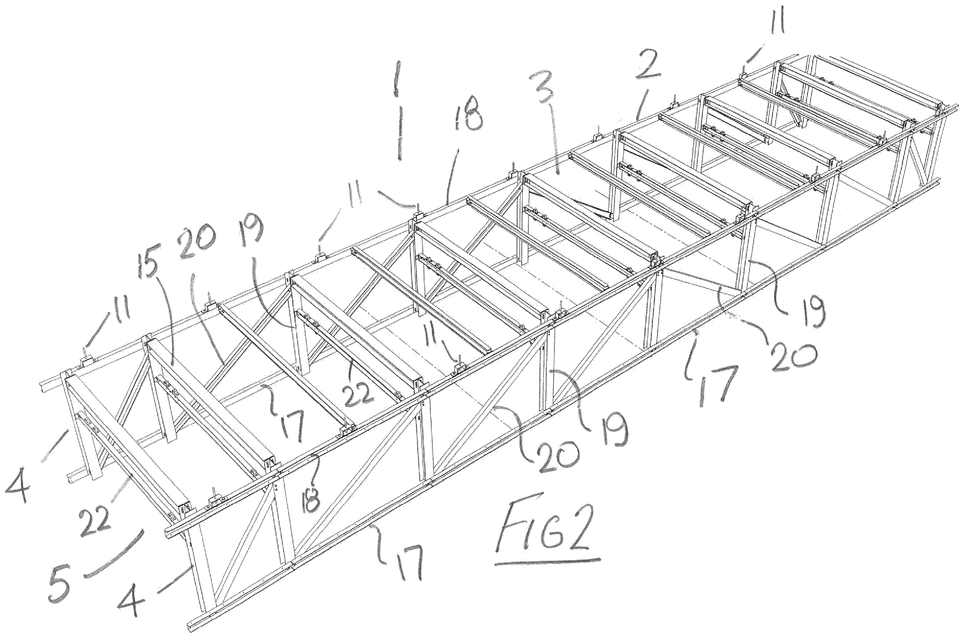

Fig. 2 is another perspective view of the frame;
Fig. 3 is a perspective view of the frame, shown in use mounted within a building;

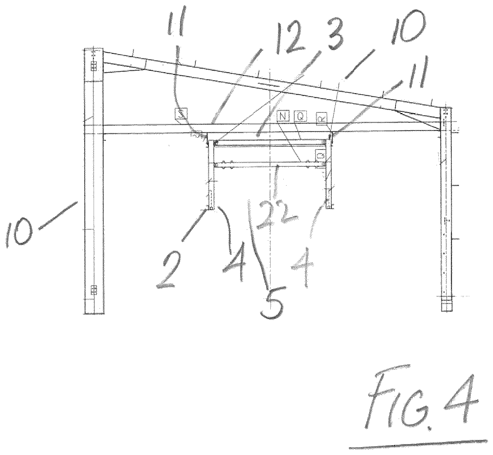

Fig. 4 is an end elevational view showing the frame mounted within the building;
Fig. 5 is a detail perspective view showing a number of window panels mounted on a side of the frame;
Fig. 6 is a front perspective view of a window panel forming portion of the system;
Fig. 7 is a rear perspective view of the window panel shown in Fig. 6;
Fig. 8 is an elevational view of the window panel shown in Fig. 6;
Fig. 9 is a side elevational view of the window panel;
Fig. 10 is a plan view of the window panel;
Fig. 11 is a side sectional elevational view of the window panel;
Fig. 12 is an enlarged detail side sectional elevational view showing portion of the window panel;
Fig. 13 is a partially exploded perspective view showing portion of a side wall of the frame;
Fig. 14 is an enlarged detail perspective view showing portion of the side wall of the frame;
Fig. 15 is an another perspective view of the side wall portion shown in Fig. 13;
Fig. 16 is an enlarged detail perspective view showing portion of the side wall;
Fig. 17 is a partially exploded perspective view showing the mounting of window panels on portion of the side wall portion;
Fig. 18 is a perspective view showing the side wall portion of the frame with window panels mounted thereon;
Fig. 19 is an enlarged detail perspective view showing portion of the side wall and a window panel;
Fig. 20 is a partially exploded perspective view of the side wall portion with window panels mounted thereon;
Fig. 21 is an enlarged detail perspective view showing portion of the side wall and a window panel;
Fig. 22 is a perspective view of the side wall portion with window panels mounted thereon;
Fig. 23 is an enlarged detail perspective view showing portion of the side wall and window panel;
Fig. 24 is a side sectional elevational view of the side wall portion and window panel;
Fig. 25 is a perspective view of the frame of the hot/cold aisle system with an alternative support means;
Fig. 26 is an elevational view of the frame arrangement of Fig. 25;
Fig. 27 is an end elevational view of the frame arrangement shown in Fig. 25;
Fig. 28 is a perspective view of transport vehicles for the system;
Fig. 29 is a perspective view of another frame of a hot/cold aisle system according to the invention;
Fig. 30 is an elevational view of the frame of the hot/cold aisle system shown in Fig. 29;
Fig. 31 is an end elevational view of the frame of the hot/cold aisle system shown in Fig. 29;
Fig. 32 is an enlarged, partially sectioned, end elevational view of the frame of the hot/cold aisle system shown in Fig. 29;
Fig. 33 is an enlarged detail, partially sectioned, view of portion of the frame;
Fig. 34 is an enlarged detail, partially sectioned, view of another portion of the frame;
Fig. 35 is a perspective view of a window panel forming portion of the frame;
Fig. 36 is an enlarged detail sectional view showing portion of the window panel;
Fig. 37 is an elevational view of the window panel; and
Fig. 38 is a plan view of the window panel.

### Detailed Description of the Preferred Embodiments

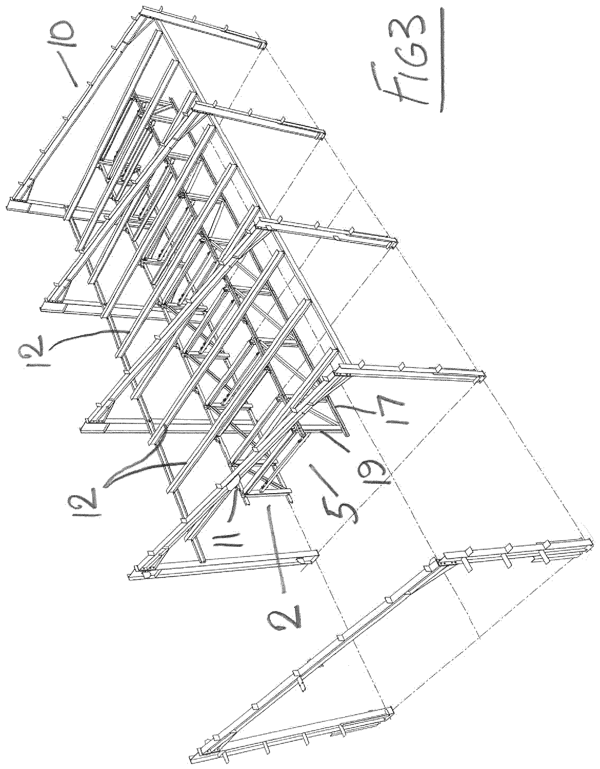

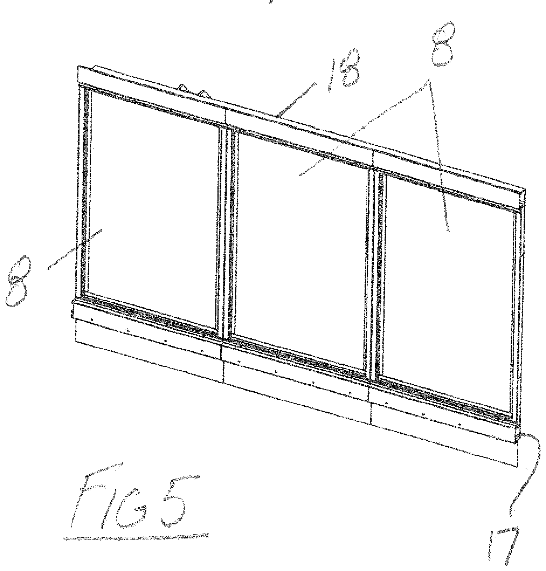

Referring to the drawings, there is illustrated a hot/cold aisle system according to the invention, indicated generally by the reference numeral 1, for a data centre. The system 1 has a prefabricated self-supporting rigid frame 2 having a top 3 and downwardly depending sides 4 defining an aisle 5 therebetween. A roof (not shown), comprising sheeting or roofing panels, is mounted on the top 3 of the frame 2 to close the top 3 of the frame 2. A plurality of side panels comprising window panels 8 (Fig. 5) are mounted along each side 4 to close the sides 4 of the frame 2. Means for mounting the frame 2 on a support such as a building structure 10 (Fig. 3) comprises a plurality of hangers 11 at the top 3 of the frame 2. In the arrangement shown in Fig. 3 these hangers 11 suspend the frame 2 from overhead rafters 12 in the building structure 10.

The frame sides 4 include a pair of spaced-apart upright side walls 4 interconnected at their upper ends by a plurality of spaced-apart crossbeams 15 forming the top 3 of the frame 2. These crossbeams 15 are perpendicular to the side walls 4. Each side wall 4 comprises a bottom rail 17 and a top rail 18 which are parallel and interconnected by a plurality of spaced-apart uprights 19 with diagonal bracing elements 20. Each bracing element 20 extends between a bottom of one upright 19 and a top of an adjacent upright 19. Each crossbeam 15 extends between upper ends of associated uprights 19 in opposite side walls 4. Intermediate crossbeams 21 may also be provided between adjacent crossbeams 15 and parallel thereto, extending between the top rails 18.

Mounted below each crossbeam 15 and extending between the uprights 19 parallel to the crossbeam 15 is a support rail 22 for mounting busbars on the frame 2 extending between opposite ends of the frame 2 adjacent each side wall 4.

The bottom rail 17 and top rail 18 of each side wall 4 comprise an outwardly facing channel. A plurality of side panels, comprising in this case window panels 8 are mounted edge to edge along each side wall 4 to close the sides of the frame 2.

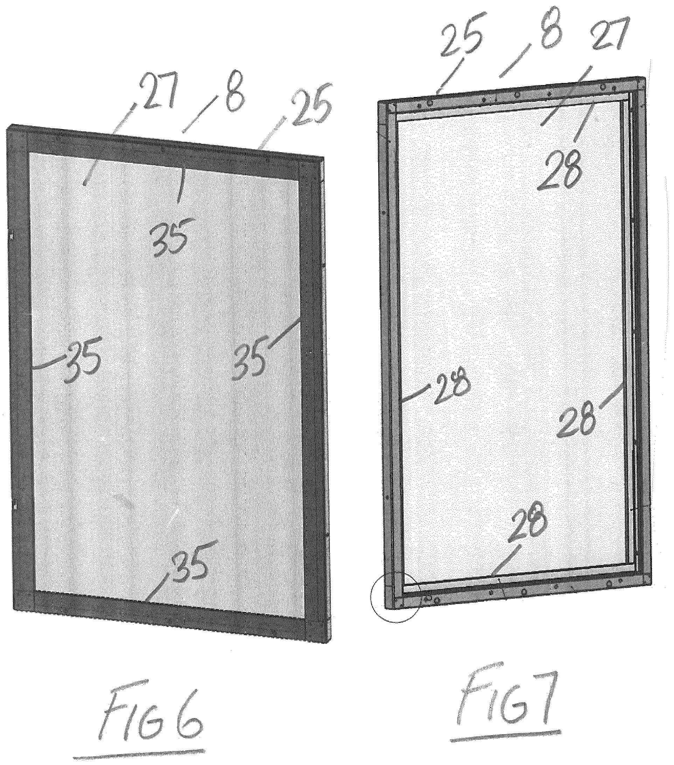

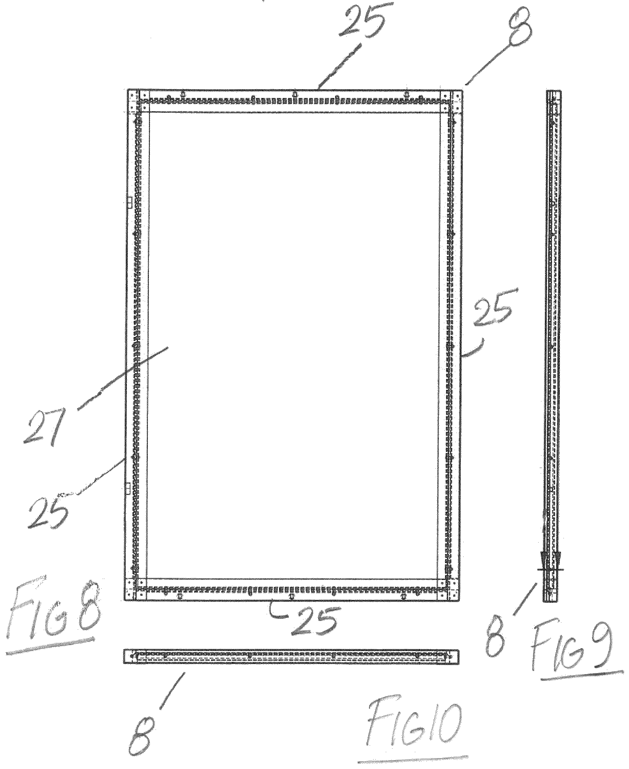

The window panels 8 are shown in more detail in Figs. 6 to 12. Each window panel 8 comprises a rectangular outer window frame 25 defining a stepped opening 26 for reception of a window pane 27. Retaining strips 28 are engagable within the stepped opening 26 to retain the window pane 27 within the stepped opening 26.

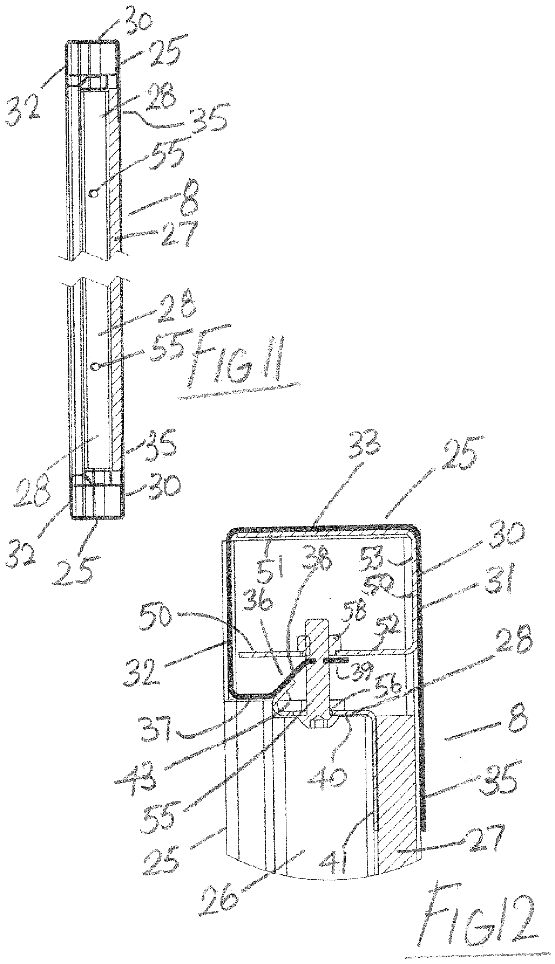

Referring in particular to Fig. 12, each side of the outer window frame 25 comprises a P-section frame member 30 having an outer wall 31 and an inner wall 32 which are parallel and spaced-apart by an outer end wall 33 extending between the outer wall 31 and the inner wall 32 and perpendicular to each of the outer wall 31 and the inner wall 32. It will be noted that the outer wall 31 extends inwardly from the outer end wall 33 further than the inner wall 32 to form a window pane mounting flange 35.

An inner end wall 36 projects inwardly from the inner wall 32 towards the outer wall 31. The inner end wall 36 is cranked intermediate its ends having an outer portion 37, a central portion 38 and an inner portion 39. The outer portion 37 and the inner portion 39 are substantially parallel and offset by the central portion 38 which is angled relative to the outer portion 37 and the inner portion 39 to form a first tapered mating face for cooperation with an associated retaining strip 28.

Each retaining strip 28 is of Z-section, having a central web 40 which lies parallel to the outer end wall 33. A window pane retaining flange 41 at an inner end of the central web 40 cooperates with the window pane mounting flange 35 to clamp the window pane 27 within the stepped opening 26. The window pane retaining flange 41 is substantially parallel to the window pane mounting flange 35, and substantially perpendicular to the central web 40.

A sliding flange 43 at an outer end of the central web 40 is folded inwardly over an outer face of the central web 40 at an acute angle to form a second tapered mating face for cooperation and sliding engagement with the central portion 38 of the inner end wall 36 of the frame member 30 to facilitate moving the window pane retaining flange 41 towards and away from the window pane mounting flange 35.

A U-shaped insert 50 is mounted within each P-section frame member 30 having parallel sides 51, 52 interconnected by a cross-member 53. The sides 51, 52 abut the outer end wall 33 and the inner portion 39 of the inner end wall 36. A fastener, which in this case comprises a locking bolt 55, is engagable through an opening 56 in the central web 40 of the retaining strip 28 and through an associated opening in the inner end wall 36 of the outer frame member 30 to engage a locknut 58 on the innermost side 52 of the insert 50 for securing the retaining strip 28 on the outer window frame 30. Typically two locking bolts 55 per retaining strip 28 are provided.

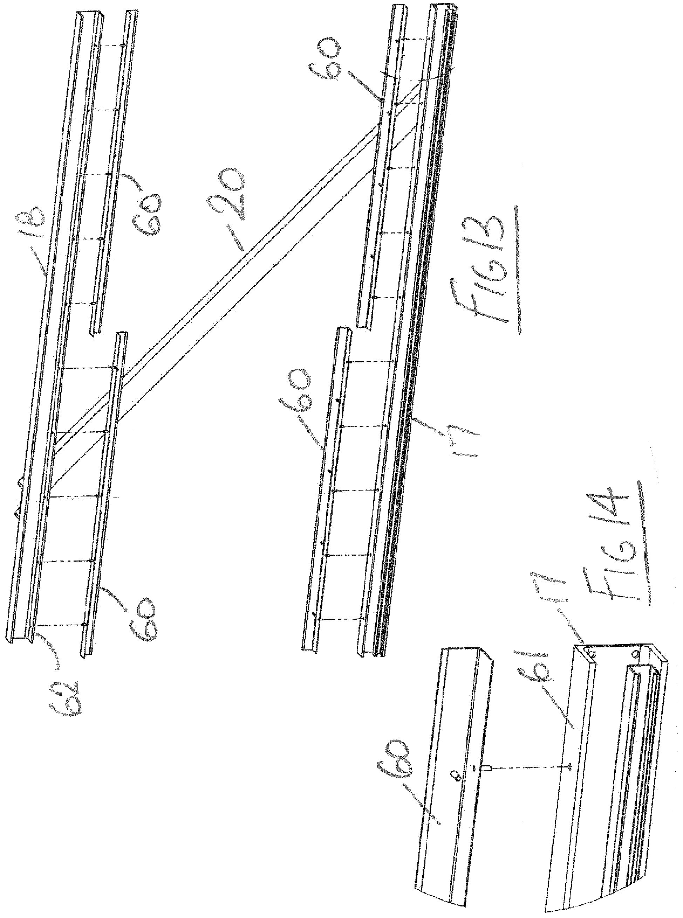

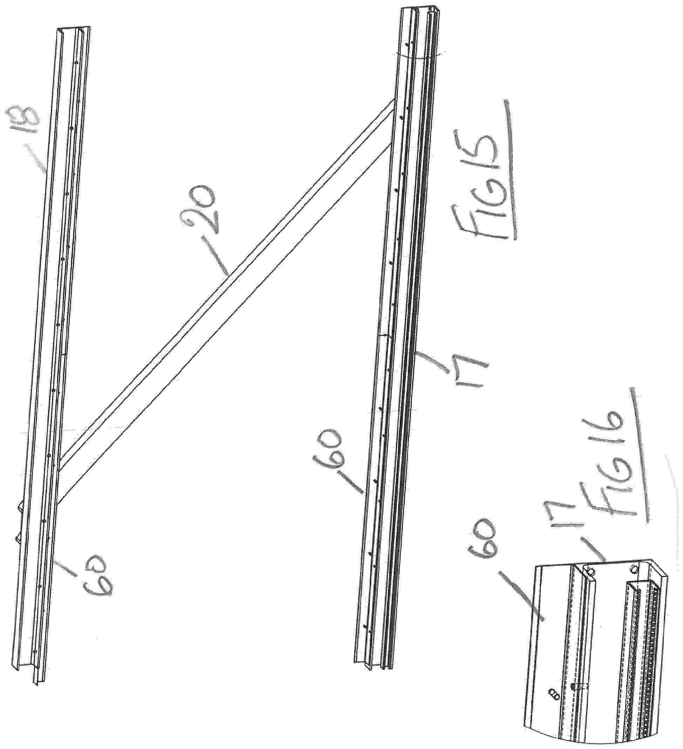

Figs. 13 to 16 show the mounting of L-shaped window panel receiver strips 60 on an inner face 61 of the bottom rail 17 and on an inner face 62 of the top rail 18.

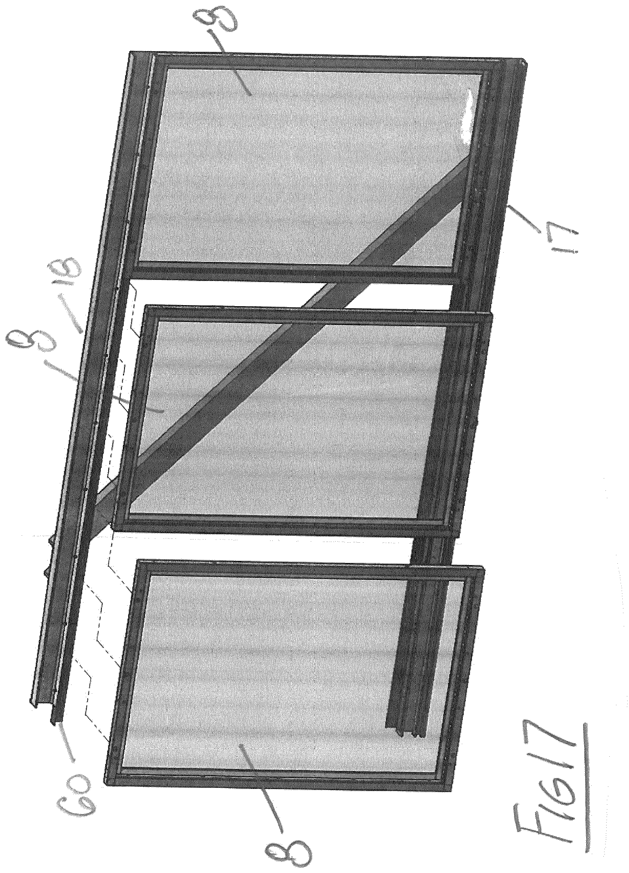

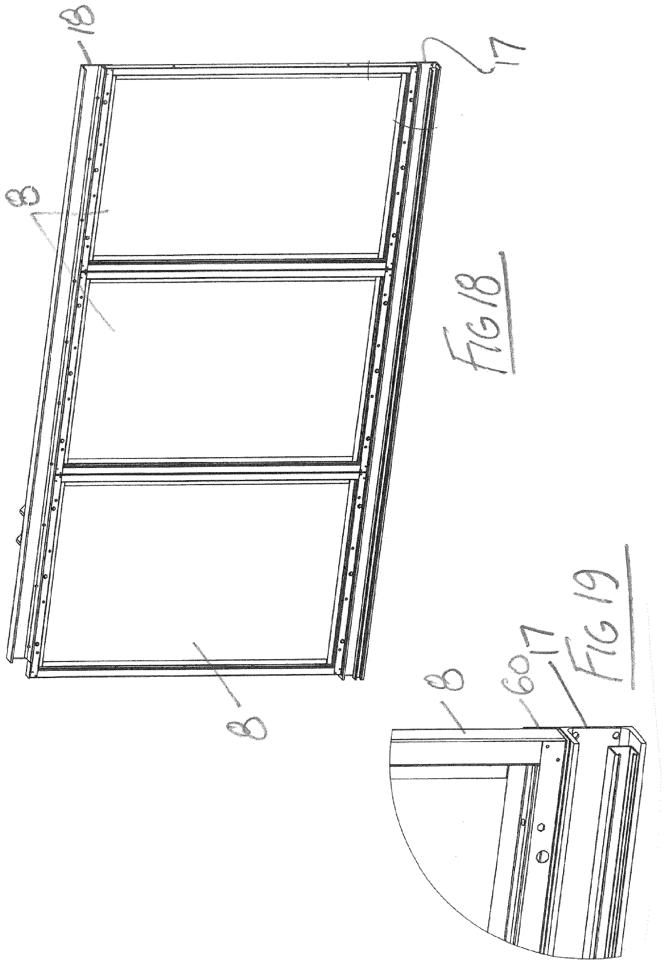

Figs. 17 to 19 show a number of window panels 8 mounted between the bottom rail 17 and the top rail 18 in engagement with the receiver strips 60. It will be appreciated that the window frames 8 can be quickly and easily mounted edge to edge along the sides 4 of the frame 2 to close the sides 4 of the frame 2.

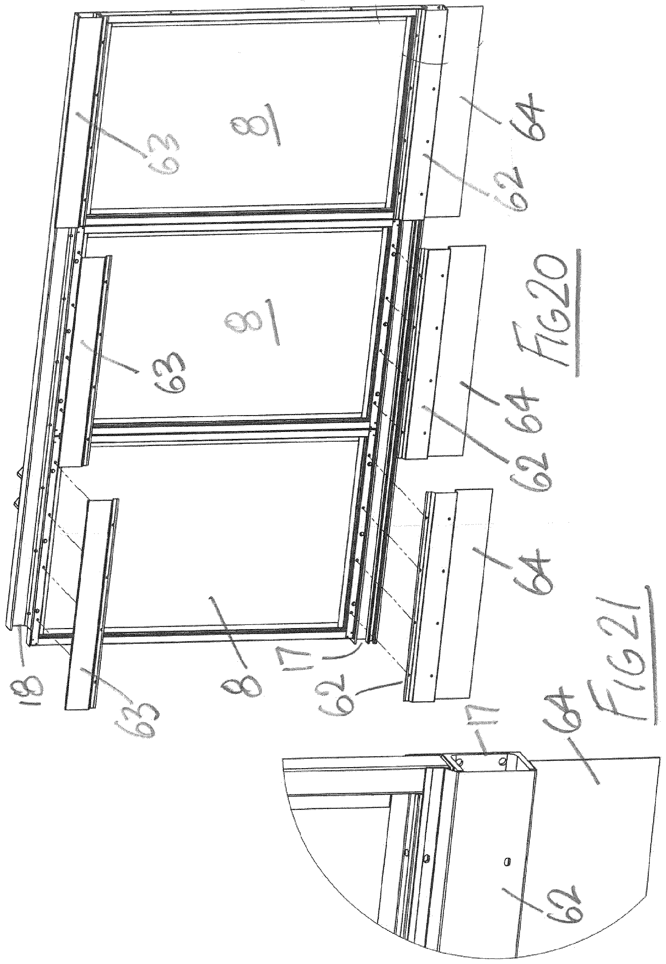

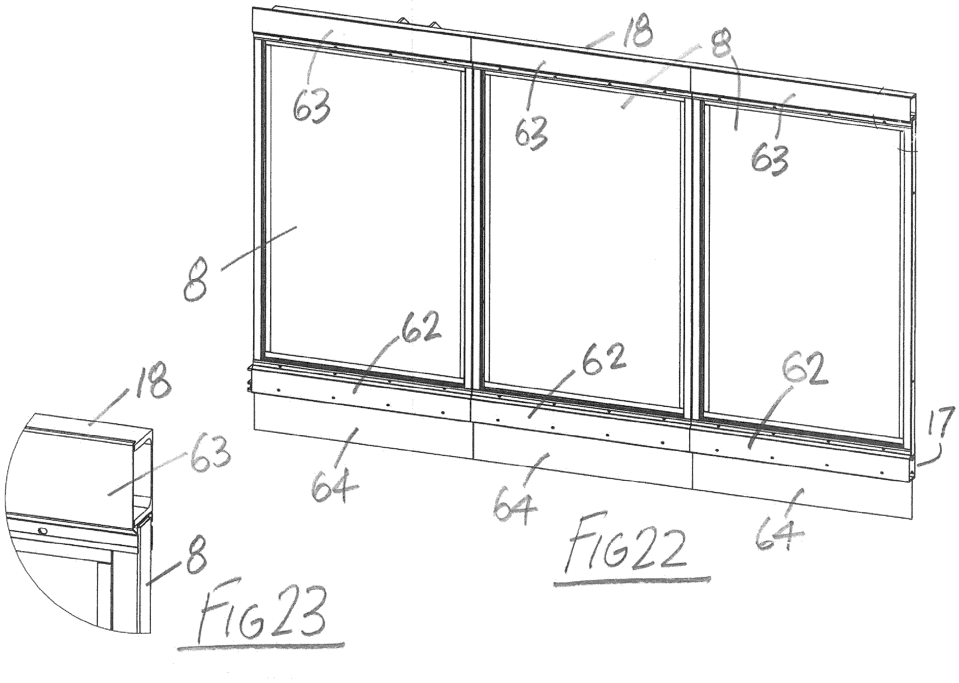

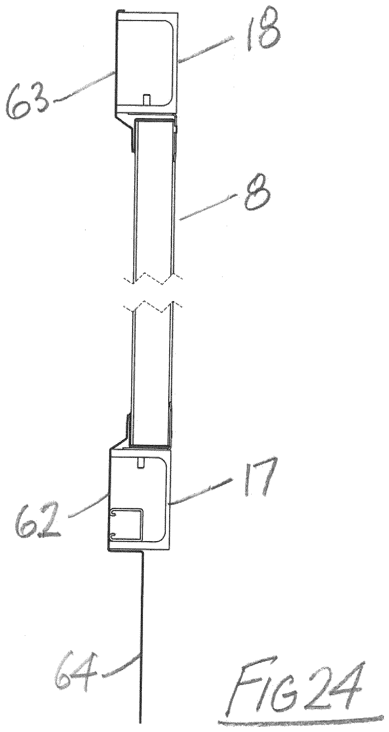

Figs. 20-24 show lower retaining plates 62 and upper retaining plates 63 which secure each window panel 8 between the bottom rail 17 and the top rail 18. It will be noted that each lower retaining plate 62 has a downwardly extending flap 64 for sealing engagement with a server switch cabinet in the data centre.

The frame 2 is of steel, and preferably the crossbeams 15 and uprights 19 are formed of steel I-beams. The bottom rail 17, the top rail 18 and the diagonal bracing elements 20 are preferably formed of channel section steel material. It will be noted that the construction is such as to form a rigid skeletal frame 2 which can be transported when assembled, thus facilitating off-site construction of the aisle system 1.

The window panes 27 comprise a translucent polycarbonate sheet with a UV protective layer.

In use, the hot/cold aisle system 1 of the invention can be pre-fabricated in a factory and then transported to the site of the data centre where it is readily, easily and quickly installed. The frame 2 can be suspended from overhead beams in the data centre by means of the hangers 11 as previously described. Alternatively, the frame 2 could be mounted on a number of ground-engaging support pillars. Providing the aisle system 1 as a self-supporting rigid frame facilitates the preparation and transport of the aisle system 1. It will be appreciated that the invention facilitates accurate construction of the aisle system 1 in a controlled and safe environment and construction can proceed in parallel with construction of the data centre, thus advoiding the delays associated with construction of an aisle system on-site and the associated delays to installation of other services at the data centre and safety concerns associated with on-site construction of an aisle system, both with regard to the workers constructing the aisle system and other workers working on other services at the site at the same time.

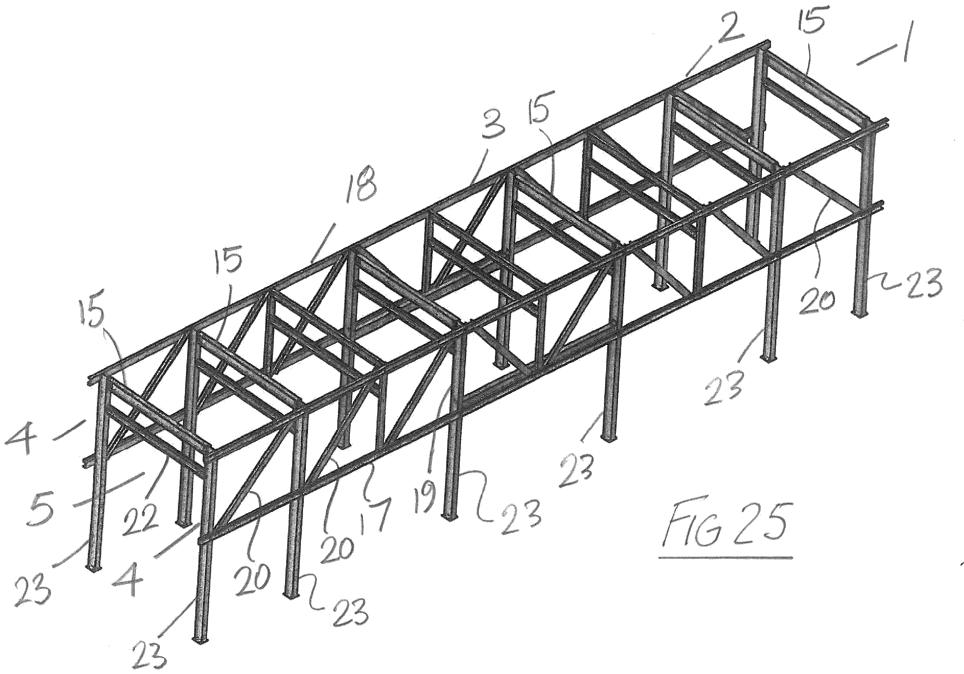

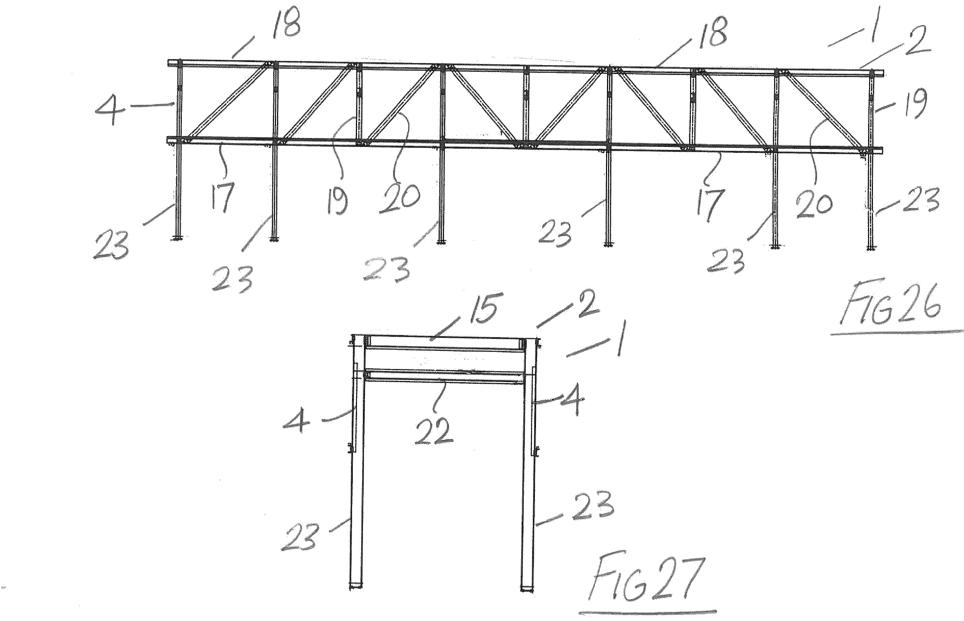

Referring now to Figs. 25 to 27, the aisle system 1 is shown with an alternative support means. Parts similar to those described previously are assigned the same reference numerals. Instead of suspending the frame 2 from a ceiling by means of hangers 11 as previously described, a number of the uprights 19 are extended downwardly of the bottom rail 17 to form support feet 23 to support the frame at a desired height above a floor on which the aisle system 1 stands in use.

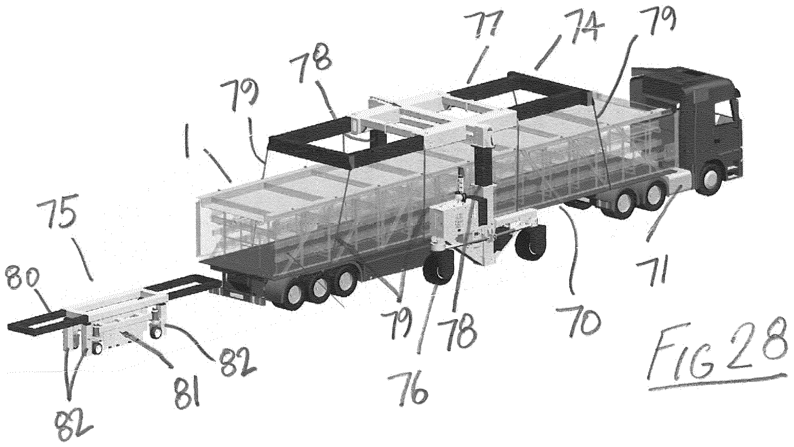

Fig. 28 shows the system 1 mounted on a semi-trailer 70 of a transport vehicle 71 to deliver the prefabricated system 1 from a factory to a site for installation. At the site, a crane 74 lifts the system 1 up off the semi-trailer 70 which is then driven out from under the system 1. A dolly vehicle 75 is then positioned below the system 1 and the crane 74 lowers the system 1 onto the dolly vehicle 75 which can be driven into position within the building in which the system 1 is to be mounted and then raised up into position for mounting on the overhead hangers 11 or the support feet 23 as previously described.

The crane 74 has a horizontal lifting frame 77 mounted between upright ram-operated telescopic support posts 78, each of which is mounted on a wheeled buggy 76. Thus, the crane 74 can position itself astride the system 1 on the semi-trailer 70 as shown in Fig. 28. Chains 79 on the lifting frame 77 are connected to the system 1. Extending the support posts 78 lifts the system 1 off the semi-trailer 70.

The dolly vehicle 75 has a lifting platform 80 mounted on a wheeled chassis 81 by ram-operated telescopic supports 82 at each corner of the chassis 81. When the system 1 is positioned on the dolly vehicle 75 by the crane 74, the dolly vehicle 75 can be manoeuvred into position and the lifting platform 80 raised by the telescopic supports 82 to a desired installation height for the system 1.

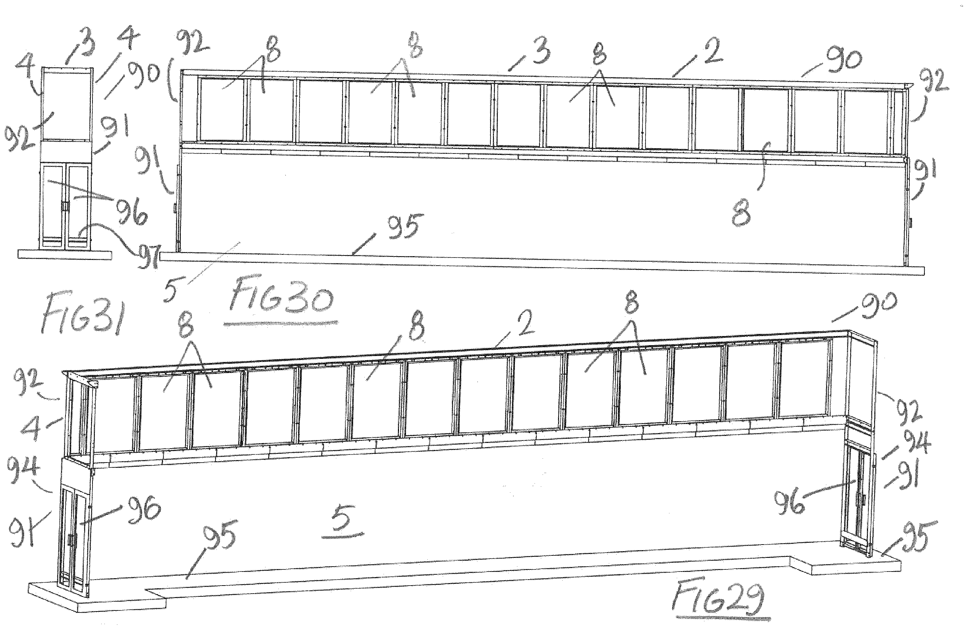

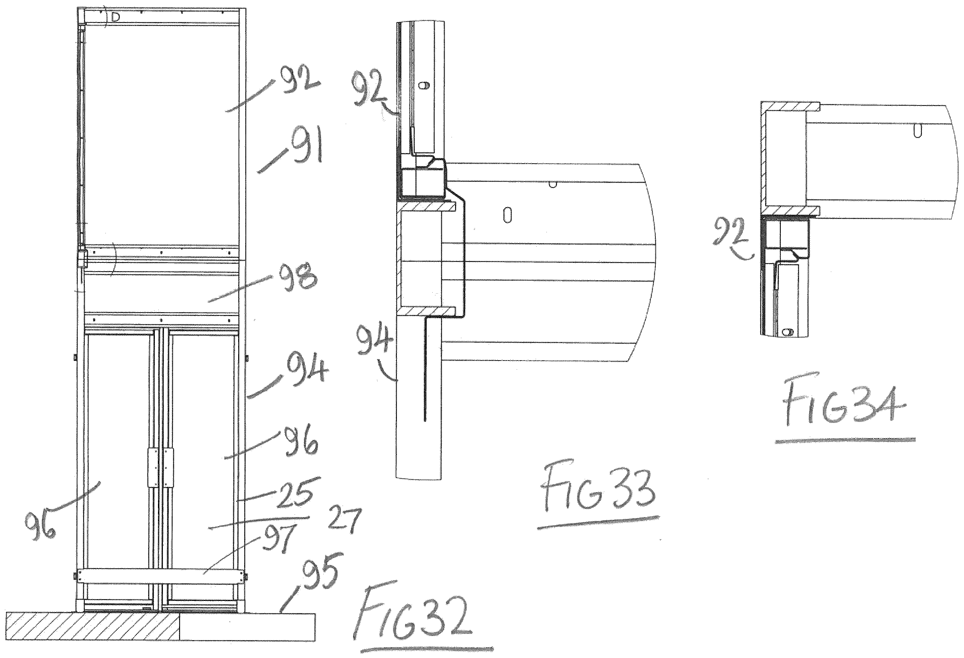

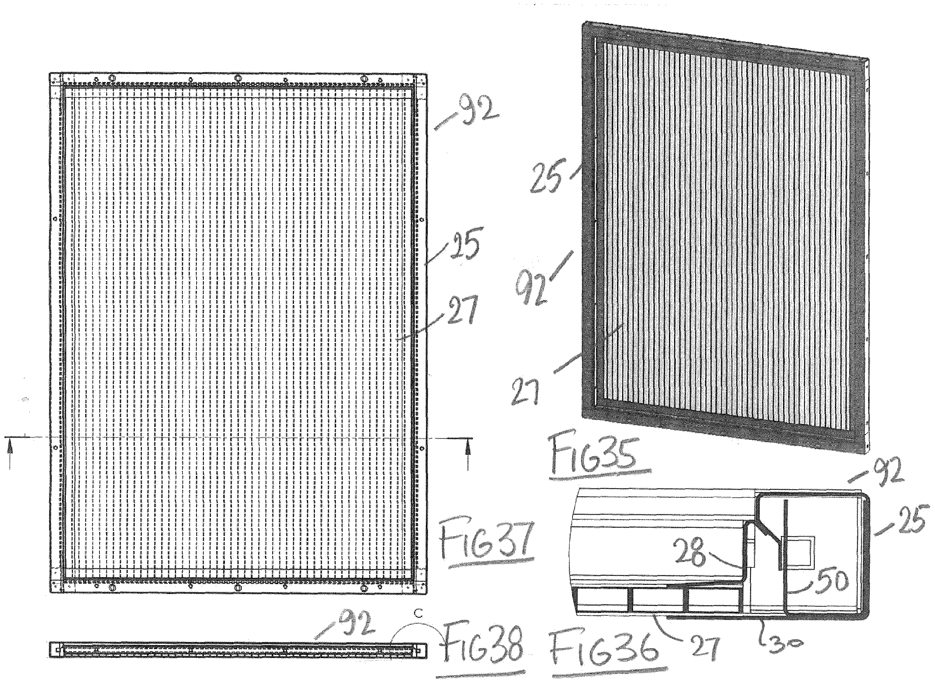

Referring now to Fig. 29 to Fig. 38, there is illustrated another hot/cold aisle system according to the invention indicated generally by the reference numeral 90, Parts similar to those described previously are assigned the same reference numerals. In this case the aisle system 90 includes a door assembly 91 at each end of the frame 2 for closing off the ends of the frame 2.

The door assembly 91 comprises an upper panel 92 which extends between the sides 4 of the frame 2 and between a top 3 and a bottom of the rigid frame 2. A door frame 94 is mounted below the upper panel 92 and extends downwardly therefrom for engagement with the ground 95 below the aisle system 90 in use. A pair of doors 96 is hingedly mounted on the door frame 94. The drawings show a bracing bar 97 mounted across a lower end of the door frame 94 for improved rigidity during transport of the aisle system 90, this being removed upon installation of the aisle system 90.

The upper panel 92 is generally of similar construction to the window panels 80 described previously and may include a window pane 27, or alternatively an opaque panel, possibly of metal, may be mounted within the frame 25 instead of the window pane 27.

The construction of the doors 96 can also be similar to the construction of the window panels 8, essentially comprising a rectangular outer frame 25 within which a window pane 27 is mounted. Again, an opaque panel may be mounted within the frame 25 if desired. A top panel 98 is mounted in the door frame 94 above the doors 96 and between the top of the doors 96 and an upper end of the door frame 94.

The terms "comprise" and "include", and any variations thereof required for grammatical reasons, are to be considered as interchangeable and accorded the widest possible interpretation.

## Claims

1. Hot/cold aisle system (1) for a data centre, including:
a prefabricated self-supporting rigid frame (2) having a top (3) and downwardly depending sides (4) defining an aisle (5),
a plurality of side panels (8) mounted edge to edge along each side (4) between a bottom rail (17) and a top rail (18) of the frame (2) to close the sides (4) of the frame (2),
the side panels (8) including a plurality of window panels (8), and
means (11, 23) for mounting the frame (2) on a support,
**characterised in that** a roof is mounted at the top (3) of the frame (2) to close the top (3) of the frame (2), and an L-shaped receiver strip (60) is mounted on an inner face (61, 62) of each of the bottom rail (17) and the top rail (18) for reception of a window panel (80) therebetween, and lower and upper retaining plates (62, 63) are provided at the bottom rail (17) and at the top rail (18) respectively to secure the window panels (8) between the bottom rail (17) and the top rail (18), the lower retaining plate (62) having a downwardly extending flap (64) for engagement with a server cabinet in the data centre in use.

2. The system (1) as claimed in claim 1, wherein the frame sides (4) include a pair of spaced-apart upright side walls (4) interconnected at their upper ends by a plurality of spaced-apart cross beams (15) forming the top (3) of the frame (2), said cross beams (15) being perpendicular to the side walls (4), each side wall (4) comprising a bottom rail (17) and a top rail (18) which are mutually parallel and interconnected by a plurality of spaced-apart uprights (19) with diagonal bracing elements (20) mounted between each adjacent pair of uprights (19).

3. The system (1) as claimed in claim 2, wherein each rail (17, 18) comprises an outwardly facing channel.

4. The system (1) as claimed in any preceding claim, wherein each window panel (8) has a translucent window pane (27) mounted on a support frame (25), each window panel (8) comprising a rectangular outer window frame (25) defining a stepped opening (26) for reception of the window pane (27), retaining strips (28) engagable within the stepped opening (26) with an inner face of associated sides of the outer window frame (25) to retain the window pane (27) within the stepped opening (26), each retaining strip (28) having a window pane retaining flange (41) at an inner end for cooperation with an inwardly extending window pane mounting flange (35) on the outer window frame (25) at a periphery of the stepped opening (26) to clamp the window pane (27) therebetween, and cooperating tapered mating faces (38, 43) at an outer end of each retaining strip (28) and on the inner face of the window frame sides for moving the pane retaining flange (41) and pane mounting flange (35) together and apart, and fasteners (55) engagable between each retaining strip (28) and the outer frame (25) to secure the retaining strip (28) on the outer frame (25).

5. The system (1) as claimed in claim 4, wherein each side of the outer window frame (25) comprises a P-section frame member (30) having an outer wall (31) and an inner wall (32) which are parallel and spaced-apart by an outer end wall (33) extending therebetween and perpendicular to the outer wall (31) and the inner wall (32), the outer wall (31) extending inwardly from the outer end wall (33) further than the inner wall (32) to form the window pane mounting flange (35), an inner end wall (36) projecting inwardly from the inner wall (32) towards the outer wall (31) and being cranked intermediate its ends to form the tapered mating face (38).

6. The system (1) as claimed in claim 4 or claim 5, wherein each retaining strip (28) is of Z-section having a central web (40) parallel to the outer end wall (33), with the window pane retaining flange (41) at an inner end of the central web (40), perpendicular thereto and parallel to the window pane mounting flange (35) of the outer window frame (25), a sliding flange (43) at an outer end of the central web (40) folded inwardly over an outer face of the central web (40) at an acute angle to form the tapered mating face (43).

7. The system (1) as claimed in claim 5 or claim 6, wherein a U-shaped insert (50) is mounted within each P-section frame member (30), having parallel sides (51, 52) interconnected by a cross-member (53), the sides (51, 52) abutting the outer end wall (33) and the inner end wall (36), a fastener comprising a locking bolt (55) engagable through associated openings in the central web (40) and the inner end wall (36) with a locknut (58) on an innermost side (52) of the insert (50) for securing the retaining strip (28) on the outer window frame (25).

8. The system (1) as claimed in any preceding claim wherein the means for mounting the frame (2) on a support comprises a plurality of spaced-apart hangers (11) at the top of the frame (2) for suspending the frame (2) from an overhead support (12).

9. The system (1) as claimed in any of claims 1 to 7 wherein the means for mounting the frame (2) on a support comprises a plurality of spaced-apart feet (23) extending downwardly from a bottom of the frame (2) to support the frame (2) at a desired height above a floor on which the aisle system (1) stands in use.

10. The system (1) as claimed in claim 9 wherein a number of the side wall uprights (19) extend downwardly of the bottom rail (17) to form the feet (23).

11. The system (90) as claimed in any preceding claim, wherein a door assembly (91) is mounted at each end of the rigid frame (2).

12. The system (90) as claimed in claim 11 wherein the door assembly (91) comprises an upper panel (92) extending between the sides (4) of the rigid frame (2) and between a top and a bottom of the rigid frame (2), and a door frame (94) mounted below the upper panel (92) and extending downwardly therefrom for engagement with the ground below the aisle system (90) in use, with a door (91) mounted on the door frame (94).

13. The system as claimed in claim 12, wherein the door (91) comprises a rectangular outer frame (25) within which a window pane (27) is mounted.

14. A method for assembling a hot/cold aisle system for a data centre as claimed in any one of the preceding claims, including the steps of pre-fabricating the hot/cold aisle system (1) in a factory, transporting the hot/cold aisle system (1) to the data centre, and installing the hot/cold aisle system (1) at the data centre.

## Patentansprüche

1. Warm-/Kaltgangsystem (1) für ein Datenzentrum, einschließlich:
einen vorgefertigten selbsttragenden starren Rahmen (2), der eine Oberseite (3) und eine nach unten weisende Seite (4) aufweist, die einen Gang (5) definieren,
eine Vielzahl von Seitenplatten (8), die Kante an Kante entlang jeder Seite (4) zwischen einer untersten Schiene (17) und einer obersten Schiene (18) des Rahmens (2) montiert ist, um die Seiten (4) des Rahmens (2) zu schließen,
die Seitenplatten (8), die eine Vielzahl von Fensterplatten (8) einschließen, und
Mittel (11, 23) zum Montieren des Rahmens (2) auf einem Träger,
**dadurch gekennzeichnet, dass** ein Dach auf der Oberseite (3) des Rahmens (2) montiert ist, um die Oberseite (3) des Rahmens (2) zu schließen, und eine L-förmiger Empfängerleiste (60) auf einer Innenfläche (61, 62) jeder der untersten Schiene (17) und der obersten Schiene (18) für einen Empfang einer Fensterplatte (80) dazwischen montiert ist, und untere und obere Halteplatten (62, 63) an der untersten Schiene (17) beziehungsweise an der obersten Schiene (18) bereitgestellt sind, um die Fensterplatten (8) zwischen der untersten Schiene (17) und der obersten Schiene (18) zu sichern, wobei die untere Halteplatte (62) eine sich nach unten erstreckende Klappe (64) für einen Eingriff mit einem Serverschrank in dem Datenzentrum in Verwendung aufweist.

2. System (1) nach Anspruch 1, wobei die Rahmenseiten (4) ein Paar beabstandeter, aufrechter Seitenwände (4) einschließen, die an ihren oberen Enden durch eine Vielzahl von beabstandeten Querbalken (15) miteinander verbunden sind, die die Oberseite (3) des Rahmens (2) ausbildet, wobei die Querbalken (15) senkrecht zu den Seitenwänden (4) sind, jede Seitenwand (4) umfassend eine unterste Schiene (17) und eine oberste Schiene (18), die zueinander parallel und durch eine Vielzahl von beabstandeten Vertikalen (19) mit diagonalen Verstrebungselementen (20) miteinander verbunden sind, die zwischen jedem angrenzenden Paar von Vertikalen (19) montiert sind.

3. System (1) nach Anspruch 2, wobei jede Schiene (17, 18) einen nach außen weisenden Kanal umfasst.

4. System (1) nach einem der vorstehenden Ansprüche, wobei jede Fensterplatte (8) eine lichtdurchlässige Fensterscheibe (27) aufweist, die auf einem Trägerrahmen (25) montiert ist, jede Fensterplatte (8) umfassend einen rechteckigen Außenfensterrahmen (25), der eine gestufte Öffnung (26) für den Empfang der Fensterscheibe (27) definiert, Halteleisten (28), die innerhalb der abgestuften Öffnung (26) mit einer Innenfläche zugeordneter Seiten des Außenfensterrahmens (25) in Eingriff bringbar sind, um die Fensterscheibe (27) innerhalb der gestuften Öffnung (26) zu halten, wobei jede Halteleiste (28) einen Fensterscheibenhalteflansch (41) an einem Innenende für eine Zusammenwirkung mit einem sich nach innen erstreckenden Fensterscheibenmontageflansch (35) auf dem Außenfensterrahmen (25) an einer Peripherie der gestuften Öffnung (26) aufweist, um die Fensterscheibe (27) dazwischen zu klemmen, und Zusammenwirken verjüngter Passflächen (38, 43) an einem Außenende jeder Halteleiste (28) und auf der Innenfläche der Fensterrahmenseiten zum Bewegen des Scheibenhalteflansches (41) und des Scheibenmontageflansches (35) zusammen und auseinander, und Befestigungselemente (55), die zwischen jeder Halteleiste (28) und den Außenrahmen (25) in Eingriff bringbar sind, um die Halteleiste (28) an dem Außenrahmen (25) zu sichern.

5. System (1) nach Anspruch 4, wobei jede Seite des Außenfensterrahmens (25) ein P-Abschnittsrahmenelement (30) aufweist, das eine Außenwand (31) und eine Innenwand (32) aufweist, die durch eine Außenendwand (33), die sich dazwischen und senkrecht zu der Außenwand (31) und der Innenwand (32) erstreckt, parallel und voneinander beabstandet sind, wobei sich die Außenwand (31) weiter von der Außenendwand (33) nach innen erstreckt, als der Innenwand (32), um den Fensterscheibenmontageflansch (35) auszubilden, wobei eine Innenendwand (36) von der Innenwand (32) zu der Außenwand (31) hin nach innen vorsteht und zwischen ihren Enden gekröpft ist, um die verjüngte Passfläche (38) auszubilden.

6. System (1) nach Anspruch 4 oder 5, wobei jede Halteleiste (28) aus einem Z-Abschnitt ist, der einen Mittelsteg (40) parallel zu der Außenendwand (33) aufweist, mit dem Fensterscheibenhalteflansch (41) an einem Innenende des Mittelstegs (40), das dazu senkrecht und parallel zu dem Fensterscheibenmontageflansch (35) des Außenfensterrahmens (25) ist, einen Verschiebeflansch (43) an einem Außenende des Mittelstegs (40), das über eine Außenfläche des Mittelstegs (40) in einem spitzen Winkel nach innen gefaltet ist, um die verjüngte Passfläche (43) auszubilden.

7. System (1) nach Anspruch 5 oder 6, wobei ein U-förmiger Einsatz (50) innerhalb jedes P-Abschnittsrahmenglieds (30) montiert ist, das parallele Seiten (51, 52) aufweist, die durch ein Querelement (53) miteinander verbunden sind, wobei die Seiten (51, 52) an der Außenendwand (33) und der Innenendwand (36) anliegen, ein Befestigungselement umfassend einen Verriegelungsbolzen (55), der durch zugeordnete Öffnungen in dem Mittelsteg (40) und der Innenendwand (36) mit einer Kontermutter (58) auf einer innersten Seite (52) des Einsatzes (50) zum Sichern der Halteleiste (28) auf dem Außenfensterrahmen (25) in Eingriff bringbar ist.

8. System (1) nach einem der vorstehenden Ansprüche, wobei die Mittel zum Montieren des Rahmens (2) auf einen Träger eine Vielzahl von beabstandeten Hängern (11) an der Oberseite des Rahmens (2) zum Aufhängen des Rahmens (2) von einem hochliegenden Träger (12) umfassen.

9. System (1) nach einem der Ansprüche 1 bis 7, wobei die Mittel zum Montieren des Rahmens (2) auf einen Träger eine Vielzahl von beabstandeten Füßen (23) umfassen, die sich von einer Unterseite des Rahmens (2) nach unten erstreckt, um den Rahmen (2) auf einer gewünschten Höhe über einem Boden zu tragen, auf dem das Gangsystem (1) in Verwendung steht.

10. System (1) nach Anspruch 9, wobei sich eine Anzahl der Seitenwandvertikalen (19) von der untersten Schiene (17) nach unten erstreckt, um die Füße (23) auszubilden.

11. System (90) nach einem der vorstehenden Ansprüche, wobei eine Türanordnung (91) an jedem Ende des starren Rahmens (2) montiert ist.

12. System (90) nach Anspruch 11, wobei die Türanordnung (91) eine obere Platte (92) umfasst, die sich zwischen den Seiten (4) des starren Rahmens (2) und zwischen einer Oberseite und einer Unterseite des starren Rahmens (2) erstreckt, und einen Türrahmen (94), der unterhalb der oberen Platte (92) montiert ist und sich davon für den Eingriff mit dem Erdboden unterhalb des Gangsystems (90) in Verwendung nach unten erstreckt, wobei eine Tür (91) auf dem Türrahmen (94) montiert ist.

13. System nach Anspruch 12, wobei die Tür (91) einen rechteckigen Außenrahmen (25) umfasst, innerhalb dessen eine Fensterscheibe (27) montiert ist.

14. Verfahren zum Anordnen eines Warm-/Kaltgangsystems für ein Datenzentrum nach einem der vorstehenden Ansprüche, einschließlich der Schritte des Vorfertigens des Warm-/Kaltgangsystems (1) in einer Fabrik, Transportieren des Warm-/Kaltgangsystems (1) zu dem Datenzentrum und Installieren des Warm-/Kaltgangsystems (1) an dem Datenzentrum.

## Revendications

1. Système d'allée chaude/froide (1) pour un centre de données, comportant :
un cadre rigide autoportant préfabriqué (2) ayant un sommet (3) et des côtés s'étendant vers le bas (4) définissant une allée (5),
une pluralité de panneaux latéraux (8) montés bord à bord de chaque côté (4) entre un rail inférieur (17) et un rail supérieur (18) du cadre (2) pour fermer les côtés (4) du cadre (2),
les panneaux latéraux (8) comportant une pluralité de panneaux de fenêtre (8), et
un moyen (11, 23) permettant de monter le cadre (2) sur un support,
**caractérisé en ce qu'un** toit est monté au niveau du sommet (3) du cadre (2) pour fermer le sommet (3) du cadre (2), et une bande de réception en forme de L (60) est montée sur une face interne (61, 62) de chacun parmi le rail inférieur (17) et le rail supérieur (18) pour réception d'un panneau de fenêtre (80) entre eux, et des plaques de retenue inférieures et supérieures (62, 63) sont fournies au niveau du rail inférieur (17) et au niveau du rail supérieur (18) respectivement pour fixer les panneaux de fenêtre (8) entre le rail inférieur (17) et le rail supérieur (18), la plaque de retenue inférieure (62) ayant un volet s'étendant vers le bas (64) pour mise en prise avec une armoire de serveur dans le centre de données en cours d'utilisation.

2. Système (1) selon la revendication 1, dans lequel les côtés de cadre (4) comportent une paire de parois latérales dressées espacées (4) interconnectées au niveau de leurs extrémités supérieures par une pluralité de poutres transversales espacées (15) formant le sommet (3) du cadre (2), lesdites poutres transversales (15) étant perpendiculaires aux parois latérales (4), chaque paroi latérale (4) comprenant un rail inférieur (17) et un rail supérieur (18) qui sont parallèles entre eux et interconnectés par une pluralité de montants espacés (19) avec des éléments d'entretoisement diagonaux (20) montés entre chaque paire adjacente de montants (19).

3. Système (1) selon la revendication 2, dans lequel chaque rail (17, 18) comprend un canal orienté vers l'extérieur.

4. Système (1) selon l'une quelconque revendication précédente, dans lequel chaque panneau de fenêtre (8) a une vitre de fenêtre translucide (27) montée sur un cadre de support (25), chaque vitre de fenêtre (8) comprenant un cadre de fenêtre externe rectangulaire (25) définissant une ouverture étagée (26) pour réception de la vitre de fenêtre (27), des bandes de retenue (28) pouvant venir en prise au sein de l'ouverture étagée (26) avec une face interne de côtés associés du cadre de fenêtre externe (25) pour retenir la vitre de fenêtre (27) au sein de l'ouverture étagée (26), chaque bande de retenue (28) ayant un rebord de retenue de vitre de fenêtre (41) au niveau d'une extrémité interne pour coopération avec un rebord de montage de vitre de fenêtre (35) s'étendant vers l'intérieur sur le cadre de fenêtre externe (25) au niveau d'une périphérie de l'ouverture étagée (26) pour serrer la vitre de fenêtre (27) entre eux, et des faces d'accouplement effilées coopérantes (38, 43) au niveau d'une extrémité externe de chaque bande de retenue (28) et sur la face interne des côtés de cadre de fenêtre pour rapprocher et éloigner le rebord de retenue de vitre (41) et le rebord de montage de vitre (35), et des éléments de fixation (55) pouvant venir en prise entre chaque bande de retenue (28) et le cadre externe (25) pour fixer la bande de retenue (28) sur le cadre externe (25).

5. Système (1) selon la revendication 4, dans lequel chaque côté du cadre de fenêtre externe (25) comprend un élément de cadre à section en P (30) ayant une paroi externe (31) et une paroi interne (32) qui sont parallèles et espacées par une paroi d'extrémité externe (33) s'étendant entre elles et perpendiculaires à la paroi externe (31) et à la paroi interne (32), la paroi externe (31) s'étendant vers l'intérieur à partir de la paroi d'extrémité externe (33) davantage que la paroi interne (32) pour former le rebord de montage de vitre de fenêtre (35), une paroi d'extrémité interne (36) faisant saillie vers l'intérieur à partir de la paroi interne (32) en direction de la paroi externe (31) et étant coudée entre ses extrémités pour former la face d'accouplement effilée (38).

6. Système (1) selon la revendication 4 ou la revendication 5, dans lequel chaque bande de retenue (28) est de section en Z ayant une âme centrale (40) parallèle à la paroi d'extrémité externe (33), avec le rebord de retenue de vitre de fenêtre (41) au niveau d'une extrémité interne de l'âme centrale (40), perpendiculaire à celle-ci et parallèle au rebord de montage de vitre de fenêtre (35) du cadre de fenêtre externe (25), un rebord coulissant (43) au niveau d'une extrémité externe de l'âme centrale (40) plié vers l'intérieur par-dessus une face externe de l'âme centrale (40) selon un angle aigu pour former la face d'accouplement effilée (43).

7. Système (1) selon la revendication 5 ou la revendication 6, dans lequel un insert en forme de U (50) est monté au sein de chaque élément de cadre à section en P (30), ayant des côtés parallèles (51, 52) interconnectés par un élément transversal (53), les côtés (51, 52) venant en butée contre la paroi d'extrémité externe (33) et la paroi d'extrémité interne (36), un élément de fixation comprenant un boulon de verrouillage (55) pouvant venir en prise à travers des ouvertures associées dans l'âme centrale (40) et la paroi d'extrémité interne (36) avec un contre-écrou (58) sur un côté le plus interne (52) de l'insert (50) pour fixer la bande de retenue (28) sur le cadre de fenêtre externe (25).

8. Système (1) selon l'une quelconque revendication précédente dans lequel le moyen permettant de monter le cadre (2) sur un support comprend une pluralité de supports d'accrochage espacés (11) au niveau du sommet du cadre (2) pour suspendre le cadre (2) à partir d'un support aérien (12).

9. Système (1) selon l'une quelconque des revendications 1 à 7 dans lequel le moyen permettant de monter le cadre (2) sur un support comprend une pluralité de pieds espacés (23) s'étendant vers le bas à partir d'un fond du cadre (2) pour supporter le cadre (2) à une hauteur souhaitée au-dessus d'un fond sur lequel le système d'allée (1) se trouve en cours d'utilisation.

10. Système (1) selon la revendication 9 dans lequel un certain nombre de montants de paroi latérale (19) s'étendent vers le bas du rail inférieur (17) pour former les pieds (23).

11. Système (90) selon l'une quelconque revendication précédente, dans lequel un ensemble porte (91) est monté au niveau de chaque extrémité du cadre rigide (2).

12. Système (90) selon la revendication 11 dans lequel l'ensemble porte (91) comprend un panneau supérieur (92) s'étendant entre les côtés (4) du cadre rigide (2) et entre un sommet et un fond du cadre rigide (2), et un cadre de porte (94) monté en dessous du panneau supérieur (92) et s'étendant vers le bas de celui-ci pour mise en prise avec le sol en dessous du système d'allée (90) en cours d'utilisation, avec une porte (91) montée sur le cadre de porte (94).

13. Système selon la revendication 12, dans lequel la porte (91) comprend un cadre externe rectangulaire (25) au sein duquel une vitre de fenêtre (27) est montée.

14. Procédé d'assemblage d'un système d'allée chaude/froide pour un centre de données selon l'une quelconque des revendications précédentes, comportant les étapes de pré-fabrication du système d'allée chaude/froide (1) dans une usine, de transport du système d'allée chaude/froide (1) vers le centre de données, et d'installation du système d'allée chaude/froide (1) au niveau du centre de données.
